# EUROPEAN PATENT APPLICATION

(11) **EP 2 842 627 A1**
(43) Date of publication of application: **04.03.2015**
(21) Application number: 13004278.1
(22) Date of filing: 30.08.2013
(51) Int. Cl.: B01J 35/02, C01G 23/07, B01J 37/08, B01J 37/34, B01J 23/40, B01J 23/50, B01J 23/52, B01J 23/72, B01J 23/75, B01J 23/755, B01J 35/10, B01J 21/06, H01L 31/0264, B01J 37/16, A61L 9/18, B01D 53/86

(54) **Visible light photoactive nanoparticles and methods for the preparation thereof**

(71) Applicant: ETH Zurich, 8092 Zurich (CH)
(72) Inventor: Pratsinis, Sotiris E., 8032 Zürich (CH); Deligiannakis, Yiannis, 45332 Ioannina (GR); Fujiwara, Kakeru, 8004 Zürich (CH)

(57) **Abstract**

A particle (1) is proposed with photoactivity under irradiation in the visible range of the electromagnetic spectrum comprising a core-particle (2) of titanium dioxide with an average diameter in the range of 3-300 nm; on the surface of said core-particle (2) nanoparticles with an average diameter in the range of 2-90 nm forming at least one metal nano-deposit (3) partially covering said surface; on the surface of said nanoparticles of at least one noble metal nano-deposit a layer containing crystalline titanium-suboxides (4) that preferably contact said core-particle (2) surface.

## Description

### TECHNICAL FIELD

The present invention relates to nanoparticles with specific architecture so they have the capability to efficiently photogenerate holes and electrons under UV-irradiation but also under visible light irradiation. Therefore they are photoactive and in particular act as a catalyst not only under UV-irradiation but also under visible light irradiation. Furthermore the invention relates to methods for making such particles in an efficient and if needed easily scalable and reliable process.

### PRIOR ART

Recently, a so-called "black TiO₂" consisting of a TiO₂ core and a distorted TiOₓ (x < 2) shell (titanium suboxide) with remarkable photoactivity under visible-light irradiation has been proposed for efficient solar energy utilization. The photoactivity preferentially occurs on the surface of these particles. A titanium suboxide shell on a core TiO₂ particle can be produced by laser irradiation or by reduction with H₂, organic solvents or CaH₂. In addition, binary TiO₂-Ti₂O₃ has been formed under extensive UV irradiation of sol-gel-made TiO₂.

The improved visible-light photoresponse of Ti suboxides involves the modulation of the energy levels of the semiconductor: Ti³⁺ defects enhance visible-light photoactivity by introducing band-gap energy states. On the other hand, the distorted titanium suboxide shell creates an additional "tail" from the valence band into the band gap. Thus, the engineering of a suboxide phase, preferably shell-type or as point Ti³⁺ reduced states on crystalline semiconducting TiO₂, opens new opportunities for visible-light-photoactive TiO₂.

Unfortunately, these techniques require extreme processing conditions such as high pressures, H₂ (or CO and NO) reduction at high temperatures, laser or UV irradiation for a prolonged period (several hours/days). Therefore, such techniques provide limited control of the phase formation so their applicability to mass production is not at least questionable.

### SUMMARY OF THE INVENTION

Visible light photoactive materials are most attractive in solar energy utilization, sensors, photovoltaics and efficient photodegradation of pollutants. For strong visible-light activity by TiO₂, a narrowing of its band gap is most promising. This is attained by creation of oxygen defects (e.g. Ti³⁺) or the formation of titanium suboxide (TiOₓ) phases. Here this is proposed by continuous, one-step, flame aerosol synthesis of layers of titanium suboxides (Ti₄O₇ and Ti₃O₅) onto nanosilver supported on nanostructured TiO₂ particles that are characterized by electron microscopy, Raman, N₂ adsorption, Diffuse reflectance and X-ray diffraction. These as-prepared crystalline suboxides are stable upon annealing, at least, up to 350 C in air for two hours. The proposed core-shell nanoparticles exhibit strong photocatalytic activity toward e.g. Cr⁶⁺ and methylene blue (half life of 15 - 55 minutes) under visible light irradiation (λ > 400 nm, 450 W).

TiO₂ and specific metals (e.g. Pt, Pd, Ni or Ag) exhibit an abnormal interaction, the so-called strong metal-support interaction (SMSI). Under H₂ reduction at high temperatures, the TiO₂ surface is reduced and the so-formed Ti³⁺ can either interact with the metal phase, thereby forming weak covalent bonds, or receive electrons from it. The so-formed Ti³⁺ can diffuse subsequently to the surface of noble metal or TiO₂ and surround them, thereby forming a shell of titanium suboxide. Indeed, the presence of Ti³⁺ on the Pt-TiO₂ surface with SMSI can be observed by X-ray photoelectron spectroscopy. Such a distorted titanium suboxide shell can also be observed also by transmission electron microscopy (TEM) in Pd-TiO₂. The chemical structure of the titanium suboxide depends on the reducing conditions. Above 600°C in H₂, Ti₄O₇ can be formed, whereas further reduction to Ti₃O₅ may require a radical reorganization of the structure.

Correspondingly therefore the present invention proposes a new type of titanium dioxide nanoparticles (typical average primary particle - as determined by nitrogen adsorption or microscopy - or crystallite - as determined by X-ray diffraction - diameter in the range of 3-300 nm preferably in the range of 3 - 90 nm or 5-40 nm) on the surface of which there are attached metal nanoparticles (typical average diameter in the range of 2-90 nm, as determined by X-ray diffraction or microscopy) preferably in the range of 2 - 50 nm or 2-10 nm), namely in only a partial coverage by a metal, preferably a noble metal such as silver. In case of partial coverage this is 0.2 -50% or 0.2 - 30%, preferably in the range of 1-27 % of the surface area of the titanium dioxide nano-particle is covered by individual separated dots of elementary (noble) metal, in the form of metal nanoparticle deposits. These elementary noble metal nanoparticles, are on the outer side at least partially, preferably completely, covered by a layer of crystalline titanium sub-oxide of variable thickness.

Apart from the particle as such and its applications as a visible light catalyst, a continuous gas-phase and proven, scalable method to kg/h, flame spray pyrolysis is proposed, for synthesis of black TiO₂ nanoparticles by simultaneous formation of TiO₂, titanium suboxide and nanosilver in one-step: Titanium and silver precursors in flammable solvents are sprayed and dispersed by O₂ in fine mists that are combusted resulting in layered (or shell) TiOₓ onto nanosilver and TiO₂ that is immobilized or supported onto core, predominantly anatase TiO₂ Nano particles. By controlling the ratio of the Ti/Ag precursor solution and dispersion O₂ flows to the FSP unit, appropriate flame conditions for particle synthesis can be selected. Silver does normally not form independently SMSIs because of its inability to dissociate molecular hydrogen to generate Ti³⁺ states; however, Ag can form SMSIs in the presence of Pt, which facilitates hydrogen dissociation. Here, abundant intermediate combustion products that can reduce TiO₂ in a manner similar to dissociated hydrogen are present in the flame that can induce SMSIs on Ti-Ag. The structural profiles of the present flame-made core-TiO₂/shell-TiOₓ NPs were investigated by TEM and X-ray diffraction (XRD). Their photoactivity was monitored by electron paramagnetic resonance (EPR) spectroscopy. Finally, the photocatalytic performance of the NPs with respect to Cr⁶⁺ and methylene blue (MB) degradation were examined under visible light (λ > 400 nm).

Specifically, the present invention relates to a particle or powder, suspension or the like of such particles with catalytic activity under irradiation in the visible range of the electromagnetic spectrum comprising a core-particle of titanium dioxide with an average diameter in the range of 10-40 nm, on the surface of said core-particle a layer or at least one noble metal nano-deposit partially covering said surface, on the surface of said layer or of said at least one noble metal nano deposit a layer of titanium-suboxide.

It was found that these particles while also showing catalytic activity under UV irradiation are showing a much higher catalytic activity under visible irradiation only than any other previously known particles.

According to a preferred embodiment of such a particle, on the surface of said core-particle at least one metal (preferably noble metal) nano deposit is located, and wherein the coverage of the total surface of said core-particle by said metal nano deposits is in the range of 0.2-50%, preferably in the range of 1-27%. According to yet another preferred embodiment of such a particle or group of particles, the layer of titanium-suboxide is contacting free surface of the core-particle of titanium dioxide.

The titanium-suboxide can be selected from the group TiₓO₂ₓ₋₁ consisting of: crystalline like Ti₃O₅, Ti₄O₇, Ti₅O₉, or a mixture and/or aggregate thereof, wherein preferably it is selected from the group consisting of: crystalline Ti₃O₅, Ti₄O₇ and where the crystalline mass ratio of Ti₃O₅, to Ti₄O₇ is preferably chosen to be in the range of 1:6 to 6:1.

The weight ratio of the titanium dioxide of the core-particle to the metal (preferably noble metal) is in the range of 29:1 - 3:1, preferably around 12:1 -4:1. The noble metal is preferably selected from the group consisting of: silver, gold, nickel, cobalt, palladium, rhodium, iridium, platinum, copper or a combination thereof, wherein it is preferably selected to be silver.

The present invention furthermore relates to a method for making such a particle or powder of such particles. According to this method preferably in a flame spray pyrolysis process titanium and silver precursors in flammable solvents are sprayed and dispersed by oxygen and combusted in a flame. During the process, titanium dioxide and silver nanoparticles are separately formed and the nanosilver deposited on the titanium dioxide nanoparticles because of the fast nucleation of titanium dioxide. Titanium suboxides are formed in the by strong metal (Ag) support (TiO₂) interactions (SMSIs).

The weight ratio of the titanium and the silver precursors in the flammable solvent is preferably adapted to be in the range of 3-90 %and preferably 7-14%..

The present method is a continuous gas-phase and scalable method to kg/h, flame spray pyrolysis (FSP), for synthesis of black TiO₂ nanoparticles (NPs) in one-step.

Furthermore the present invention relates to uses of such particles, preferably made according to a method as outlined above as a visible light photo catalyst, or in solar energy utilisation. In the context of such a use the particles can be used for oxidation reactions and/or photodegradation reactions, in particular of pollutants.

Further embodiments of the invention are laid down in the dependent claims.

### BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

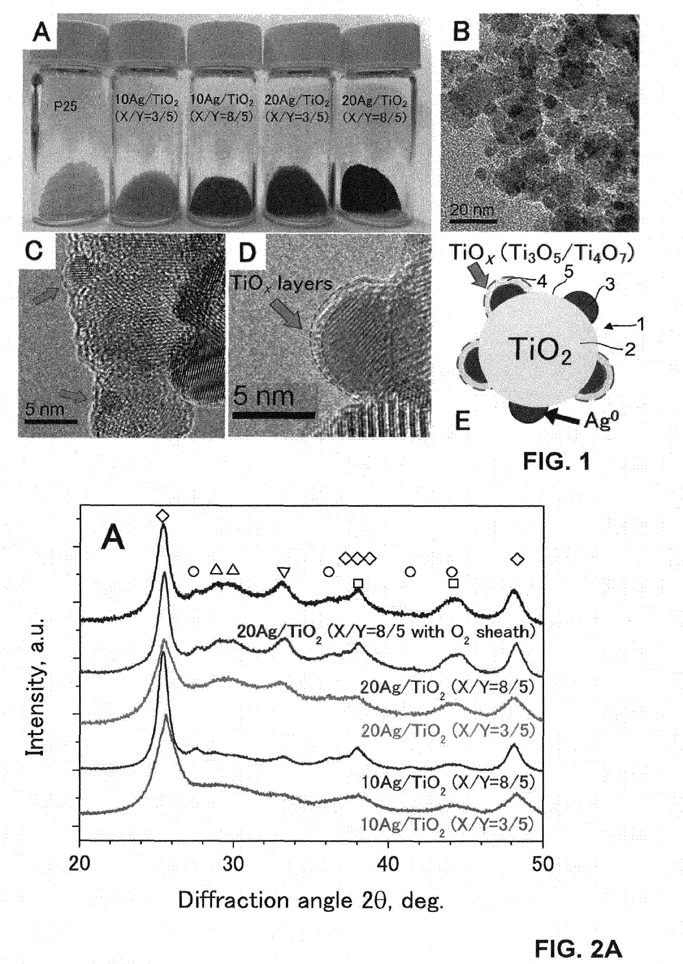

- Fig. 1: shows in (A) commercial TiO₂ (P25) and FSP-made TiO₂ loaded with Ag (10 or 20 wt.%) prepared at low (X/Y = 3/5) and high (8/5) temperature and Ti concentration flames; (B) TEM image of 20Ag/TiO₂ made at X/Y = 8/5 with selected (C, D) high-resolution images; the arrows and broken lines indicate a distorted titanium oxide layer on nanosilver and the TiO₂ support; (E) Schematic of present titanium suboxide-encapsulated nanosilver on TiO₂ induced by strong metal support interactions (SMSI);

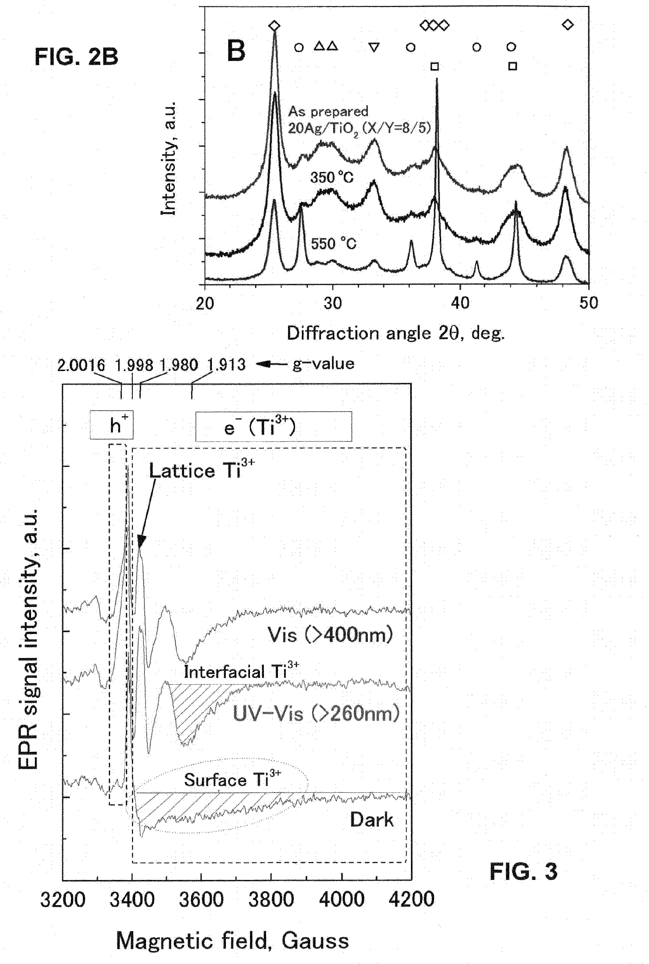

- Fig. 2: shows XRD patterns of (A)10Ag/TiO₂ or 20Ag/TiO₂ prepared at FSP feed X/Y = 3/5 or 8/5 and 20Ag/TiO₂ prepared at X/Y = 8/5 with 20 L/min of sheath O₂, and (B) 20Ag/TiO₂ prepared at X/Y = 8/5 (as in Fig. 2A) and annealed at 350 or 550°C in air for 2 h; TiO₂ Diffraction patterns are marked for TiO₂ anatase (diamonds) and rutile (circles) as well as for Ag⁰ (squares), Ti₄O₇ (up triangles) and Ti₃O₅ (down triangle);
- Fig. 3: Electron paramagnetic resonance (EPR) spectra for the 20Ag/TiO₂ NPs prepared at X/Y = 8/5 and recorded at 77 K in the dark (bottom; prior to illumination), after illumination with UV-Vis radiation (middle; λ > 240 nm), or Vis radiation (top; λ > 400 nm);

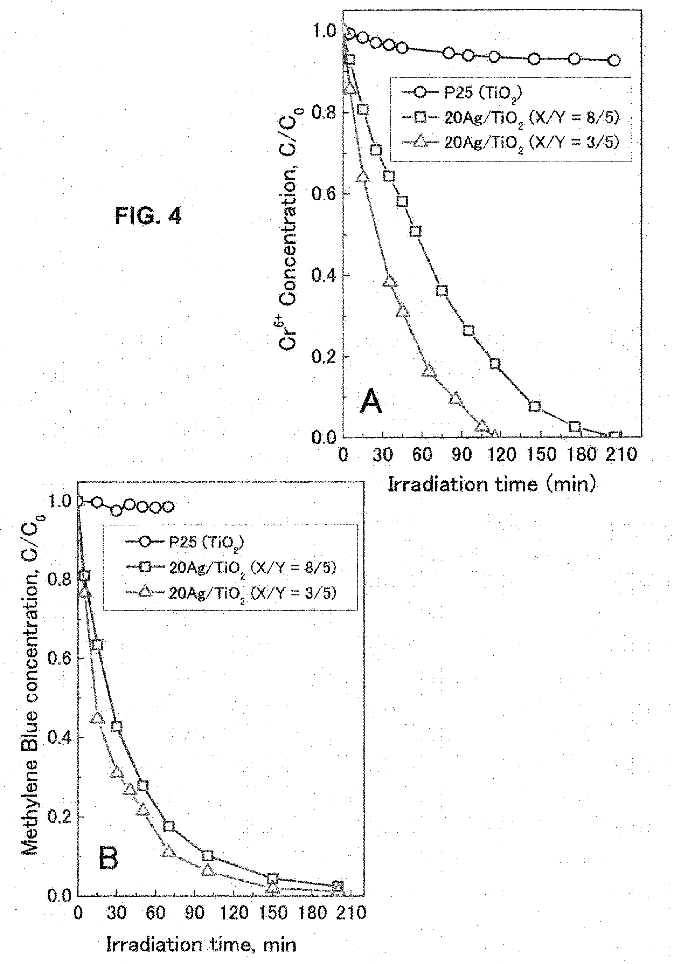

- Fig. 4: Photocatalytic reduction of (A) Cr⁶⁺ ions and (B) Methylene blue by pure TiO₂ (commercial P25, black circles) and 20Ag/TiO₂ prepared by flame spray pyrolysis at X/Y = 3/5 (orange triangles) or 8/5 (green squares) under visible-light irradiation (λ > 400 nm, 450 W); the presence of TiOₓ layers containing nano crystalline Ti₄O₇ and Ti₃O₅ onto nanosilver supported on nano TiO₂ facilitate the attainment if very short photodegradation half-life, 25-55 min for Cr⁶⁺ and 15-25 min for methylene blue;

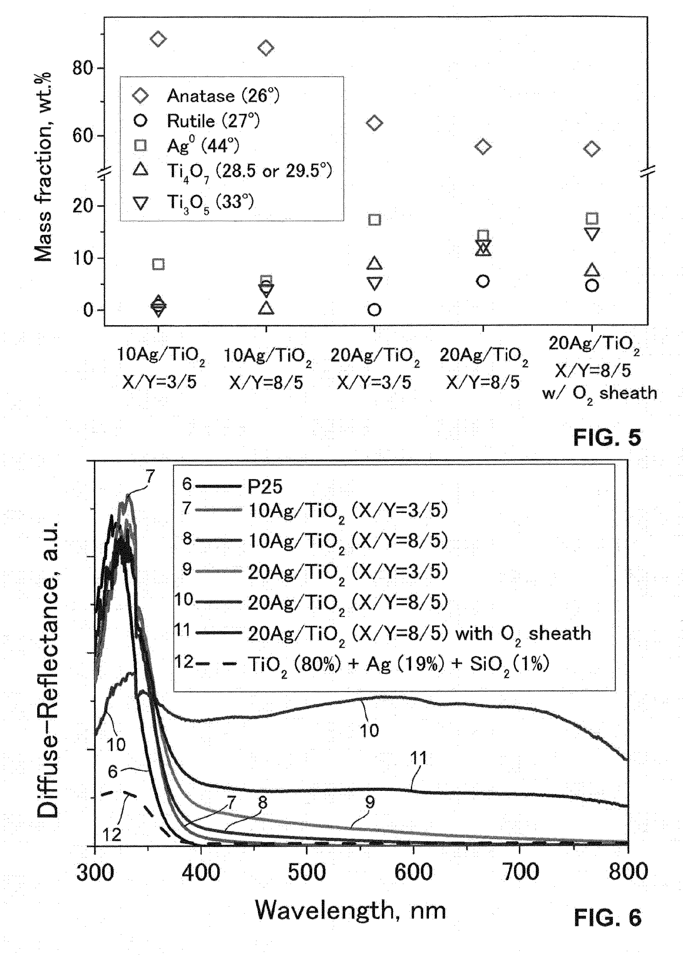

- Fig. 5: XRD-mass fractions of anatase (diamonds), rutile (circles), Ag⁰ (squares), Ti₃O₅ (down triangles), and Ti₄O₇ (up triangles) phases for all FSP-made samples; a background signal corresponding to amorphous crystals was corrected in the spectra by software (EVA); the fractions were calculated from the integral intensities of each XRD peak as obtained by software (OriginPro, 8.6); as the peaks for Ti₄O₇ at 28.5° and 29.5° overlap, the integral intensity for Ti₄O₇ was assumed to be half of the area for the peak at 29.5°; the anatase mass fraction decreased by the formation of rutile and titanium suboxides (Ti₃O₅ and Ti₄O₇); the Ag⁰ mass fractions for all particles were slightly lower than the nominal Ag atom loading (10 or 20 wt.%) and decreased by the formation of titanium suboxide phases (Ti₃O₅ and Ti₄O₇); the decrease in Ag⁰ mass fraction might be attributed to the interaction of isolated Ag atoms with Ti³⁺. Such Ag atoms can be formed by electron transfer from Ag to titanium;
- Fig. 6: Diffuse reflectance (DR) absorption spectra of commercial TiO₂; "black" TiO₂ NPs loaded with Ag (10 and 20 wt.%) prepared at FSP feed ratios of X/Y = 3/5 and 8/5 in the absence or presence of O₂ sheath gas (20 L/min) and mechanically mixed 20 wt.% of 95Ag/SiO₂ and 80 wt.% of TiO₂ (P25, black broken line); the 20Ag/TiO₂ particles show significant absorption from 360 to 800 nm, which is the origin of their characteristic black color (Fig. 1A); the mechanically mixed TiO₂-Ag⁰ (supported on SiO₂) particles do not show any visible absorption, the improved absorbance at visible wavelengths (400 - 800 nm) of the present FSP-made Ag/TiO₂ over commercial nano-TiO₂ (P25) with or without equivalent nanosilver mass is therefore attributed to the presence of the titanium suboxides;

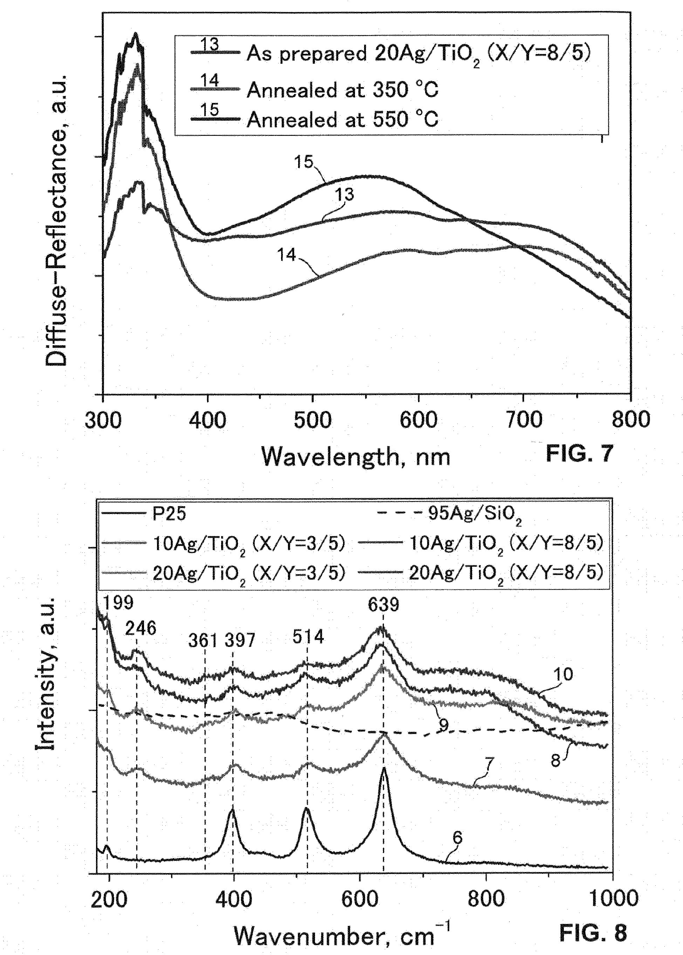

- Fig. 7: Diffuse reflectance absorption spectra of 20Ag/TiO₂ NPs "as prepared" at FSP feed ratio X/Y = 8/5 and annealed at 350 or 550°C in air for 2 h. At 350°C, UV absorption of 20Ag/TiO₂ increases but in the visible decreases; this indicates surface oxidation of suboxide layers, which is analogous with the 20Ag/TiO₂ NPs prepared at X/Y = 8/5 in the presence of sheath O₂ (Fig 6); by annealing at 550°C, the UV absorption further increases, compared to that at 350°C as further conversion of suboxides and anatase to rutile took place (Fig. 2B); furthermore, the plasmonic absorption of Ag around 550 nm was revealed by removal of the Ti-suboxide layers with Ag⁰ sintering and crystal growth (Fig. 2B);
- Fig. 8: Raman spectra of black TiO₂ NPs loaded with Ag (10 or 20 wt.%) and prepared at X/Y = 3/5 or 8/5; for comparison, the Raman spectra of commercial TiO₂ (P25, Degussa) and FSP-made Ag (95 wt.%) supported on SiO₂ NPs (95Ag/SiO₂) are also included; commercial TiO₂ (black solid line) gives the well-known four peaks at 199, 397, 514, and 639 cm⁻¹ that are typical for anatase; notably, no Raman peak for silver (95Ag/SiO₂, dashed line) was detected; thus, the Raman peaks detected for the Ag/TiO₂ NPs correspond to pure TiO₂ or titanium suboxide phases; when the Ag loading is increased from 10 to 20 wt.% and/or the flame conditions becomes more reducing (by increasing the precursor/fuel stream for 3 to 8 mL/min), the anatase peaks at 514 and 639 cm⁻¹ are broadened, and the peak intensity at 199 cm⁻¹ is increased; most importantly, then the new peaks at 246 and, to some extent at 361 cm⁻¹ become stronger; analogous features have been observed in the Raman spectra of shell-type, H2-reduced titanium suboxides (1, 2);

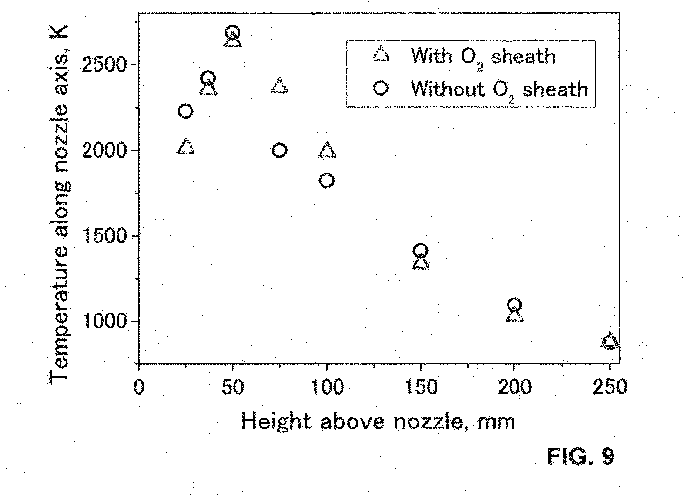

- Fig. 9: Axial flame temperatures during FSP synthesis 20Ag/TiO₂ at feed rate X/Y = 8/5 with (triangles) and without (circles) O₂ sheath; the temperature was measured by non-intrusive Fourier transform infrared (FITR) emission and transmission spectroscopy; the FTIR spectra ranged from 500 ∼ 8000 cm⁻¹ with 32 cm⁻¹ resolution and were obtained by an FTIR spectrometer (Bomen MB155S); path correction spectra for the emission measurements were taken by a blackbody cavity (PYROcal LAB, TRANS-METRA GmbH); the flame temperature is an integral along the IR beam of ∼4 mm in diameter through the flame centerline at different heights above the FSP nozzle tip; the O₂ sheath does not affect the maximum flame temperature (∼2700 K); downstream from the maximum, the temperature decreases with cooling by entrainment flow; the cooling rate in the presence of sheath O₂ is slightly slower downstream from the maximum than that in its absence, increasing the high temperature particle residence time; this might explain the formation of Ti₃O₅ (with sheath O₂ flow, Fig. 5) that requires higher energy.

### DESCRIPTION OF PREFERRED EMBODIMENTS

**Methods:** Core-TiO₂/shell-titanium suboxide ("black" TiO₂) NPs loaded with 10 or 20 wt.% of Ag (10Ag/TiO₂ or 20Ag/TiO₂), the percentages always being calculated with respect to the total weight of the particles, were prepared in a single step by FSP and were collected on glass-fiber filters. Silver acetate (Aldrich, purity > 99%) and titanium (IV) isopropoxide (TTIP, Aldrich, purity > 97%) were used as silver and titanium precursors, respectively. The total precursor (TTIP and silver acetate) concentration in a 1:1 mixture of 2-ethylhexanoic acid (Aldrich, purity > 99%) and acetonitrile (Aldrich, purity > 99.5%) was 0.16 M. The precursor solution was fed through the FSP capillary nozzle at X = 3 or 8 mL/min, dispersed to a fine spray by Y = 5 L/min oxygen flow (Pan Gas, purity > 99%) (hereafter referred to as the FSP X/Y feed ratio) and combusted to produce high-purity NPs. Additionally, 20Ag/TiO₂ NPs was prepared at X/Y = 8/5 with a sheath of O₂ flowing at 20 L/min through an annulus surrounding the O₂ dispersion.

High-resolution TEM was performed with a Tecnai F30-ST microscope (FEI, operated at 300 kV, point resolution ∼2 Å). As-prepared particles were dispersed in ethanol and deposited onto a perforated carbon foil supported on a copper grid. XRD patterns were obtained using a Bruker AXS D8 Advance diffractometer (Cu Kα, 40 kV, 40 mA) at 2θ = 20°-50° with a step size of 0.03°. The exposure time for each step was set to 2.5 s to obtain high-quality XRD patterns.

EPR spectra were recorded with a Bruker ER200D spectrometer at liquid-N₂ temperatures, equipped with an Agilent 5310A frequency counter. For each experiment, 10 mg of NPs are placed inside a quartz EPR tube (Suprasil, Willmad Glass) with an outer diameter of 3 mm. The EPR signals presented herein were recorded at 9.49 GHz, using a modulation amplitude of 4 G, a field modulation of 100 kHz, and a microwave power of 4 mW. Adequate signal-to-noise ratios were obtained with 10 scans. A solar-light-simulating Xe light source (Oriel model 66929, 450 W) equipped with a water IR filter was used to investigate photogeneration of electrons and holes. Visible-light illumination (λ > 400 nm) was performed using a longpass 400 nm filter (Edmund Optics 85754). The same light source was used for photocatalytic experiments.

Photocatalytic Cr⁶⁺ and methylene blue (MB) degradation was preformed in a Pyrex glass container. For Cr⁶⁺ degradation, 9 mg of NPs was dispersed in 90 mL of Milli-Q water (C_{catalyst} = 100 mg/L) in a water-bath sonicator. The solution pH was adjusted to 3.5 with HNO₃. K₂Cr₂O₇ (Aldrich) was added at an initial concentration of C_{Cr} = 0.5 mM. Salicylic acid (SA) (Aldrich) was added at a concentration of C_{SA} = 5 mM to optimize the photocatalytic kinetics. For MB degradation, 22.5 mg of NPs were dispersed in 90 mL of Milli-Q water (C_{catalyst} = 250 mg/L) in a water-bath sonicator. Methylene blue (Aldrich) was added at an initial concentration of C_{MB} = 0.01 mM. The solution pH was adjusted to 9.0 with NaOH. The solutions were mixed with the appropriate amount of photocatalyst and magnetically stirred before and during the illumination. The suspensions were kept in the dark for 30 min prior to illumination to reach adsorption equilibrium on the semiconductor surface. As the reaction progressed, samples were withdrawn from the reactor at specific time intervals. MB suspension was centrifuged for 15 min at 4000 rpm using a Hettich Universal 16A centrifuge for further analysis. The MB decolorization was determined by monitoring the change in optical absorption at 660 nm using a Perkin Elmer Lambda 35 double-beam UV-Vis spectrophotometer. The Cr⁶⁺ ions in each solution were determined by the diphenylcarbazide method using the UV-Vis spectrophotometer. Results: Figure 1A compares images of P25 (commercial TiO₂) and titanium oxide NPs loaded with Ag (10 or 20 wt.% of composite Ag/TiO₂ particles) prepared at FSP X/Y feed ratio (the ratio between the feed rates of the Ag/Ti precursor solution, X mL/min, and dispersion O₂, Y L/min) = 3/5 (low precursor concentration) or 8/5 (high precursor concentration). A high Ag loading (e.g. 20 wt.%) and a high FSP feed ratio (e.g. 8/5) resulted in the darkest particles (Fig. 1A). The dark particle colors are similar to those of Hz-reduced TiO₂. This dark color is not due to incomplete combustion products i.e. carbon, remaining on particle surface as confirmed by thermogravimetric analysis, which shows < 2% of organic loading, and EPR which shows zero carbon-based radicals. However, the typical plasmonic absorption band of Ag⁰ (supported on TiO₂) around 550 nm was not observed (see Figure 7). The absence of this band is attributed to a strong electron interaction between Ag-Ti induced by SMSI. Therefore, the color changes correspond to the formation of titanium suboxide, which exhibits an absorption band in the visible range. Figure 1B shows a TEM image of 20Ag/TiO₂ NPs prepared at X/Y = 8/5 with its higher resolution and magnifications at 1C and 1D. The lighter and darker parts correspond to titanium oxide and Ag⁰, respectively. A closer inspection of Figures 1C,D, however, reveals a distorted layer onto the darker Ag NPs (indicated by broken red lines). Similar morphologies have been observed on strongly interacting Co and Pt nanostructures on TiO₂ produced by H₂ reduction at high temperatures. This morphology indicates SMSIs that result in coating of noble metals by titanium suboxides. Figure 1E shows schematically such distorted suboxide layers encapsulating nanosilver in Figures 1C,D (indicated by arrows). This coating hinders nanosilver oxidation and leaching or release of Ag⁺ ions in aqueous solutions. This suppression of Ag⁺ ion release is attributed to the Ti-suboxide formation. So the Ag⁺ release (or leaching) from the present Ag/TiO₂ particles is 61-87 % less than that by similar, flame-made nanosilver supported on SiO₂ and suspended in water (see Table 1). For example, Ag NPs (dp = 4.5 nm for 10Ag/TiO₂ made at X/Y = 8/5) release 20.9 % of their mass as Ag⁺ ions, whereas such Ag NPs on SiO₂ release 62 % of their mass as Ag⁺ ions. This 66 % inhibition of Ag⁺ ion leaching is consistent with that other FSP-made TiO₂ NPs loaded with 5 wt.% of Ag that reduced the Ag⁺ ion release by 72 % compared to that from Ag supported on SiO₂. The suppression of the Ag⁺ ion release by the Ti suboxide coating is analogous to the hindering of chemisorption on noble metals during SMSI.

**Table 1. Ag⁺ ion release from FSP-made Ag/TiO₂ NPs prepared at different FSP feed ratios**

| Samples | As prepared particles | | | | | |
|---|---|---|---|---|---|---|
| Composition | 10Ag/TiO₂ | | 20Ag/TiO₂ | | | 5Ag/TiO₂ (*18*) |
| FSP synthesis conditions | X/Y = 3/5 | X/Y = 8/5 | X/Y = 3/5 | X/Y = 8/5 | X/Y = 8/S, w/ O₂ sheath | X/Y = 5/5 |
| Specific surface area [m²/g] | 238 | 117 | 208 | 113 | 126 | None |
| Ag⁰ (crystal) size at 44° [nm] | 2.8 | 4.5 | 3.2 | 5.0 | 4.6 | 2.0 (primary Ag size) |
| Observed Ag⁺ ion release [wt.%] | 34.9 | 20.9 | 12.6 | 6.9 | 11.81 | 27 |
| Calculated Ag⁺ ion release from nanosilver supported on SiO₂ [wt.%] | 90 | 62 | 84 | 52 | 60 | 95 |
| Net suppression of Ag⁺ ion release from nanosilver supported on TiO₂ with Ti-suboxide layering than SiO₂ [%] | 61 | 66 | 85 | 87 | 80 | 72 |

| | | | | | | |
|---|---|---|---|---|---|---|
| The crystal sizes of Ag⁰ were obtained by Rietveld analysis (TOPAS 4.0) of the XRD spectra at 44° (Ag⁰. The Ag⁺ ion concentration in de-ionized water containing 100 mg/L of nanosilver was measured with an ion-selective electrode and an ion meter (both Metrohm). The suppression of Ag⁺ ion release was calculated by the difference between the calculated Ag⁺ ion release on SiO₂ and the observed one on TiO₂ here divided by the former. | | | | | | |

Figure 2A shows the XRD patterns of the 10 and 20Ag/TiO₂ NPs prepared at X/Y = 3/5 or 8/5, respectively. A higher FSP feed ratio (e.g. X/Y = 8/5) results in stronger and sharper peaks indicating larger crystals. Increasing the X/Y ratio increases particle mass concentration and residence time at high temperatures that lead to larger particles by enhanced coagulation and sintering. The peaks at 25.5° and 48° correspond to anatase TiO₂ (diamonds) that are dominant in all particles made here. Only particles prepared at X/Y = 8/5 contain a small peak around 27.5° corresponding to rutile (circles). The Ag⁰ peaks (squares) resolved at 44° show a distorted shape compared with flame-made Ag⁰ NPs supported on SiO₂ indicating the SMSI between Ag and TiO₂ here.

Most interestingly, titanium suboxide peaks were resolved in the XRD patterns: Ti₃O₅ (down triangle) at 33° and Ti₄O₇ (up triangles) at 28.5° and 29.5° in Fig. 2A. Analogous features have been reported for Ti₃O₅ and Ti₄O₇ phases formed by SMSI. Here, the suboxide peaks are broad, indicating small crystals and/or low crystallinity consistent with their layered formation onto nanosilver (Fig. 1C, D). The peak intensities increased with Ag loading and FSP feed ratio (reducing flame conditions) corresponding to the darkening of these particles (Fig. 1A).

The use of additional O₂ as a sheath gas in the FSP unit, which makes the flame more oxidative, affected the suboxide phase formation, as shown in Fig. 2A (purple spectrum). The mass fraction of Ti₄O₇ decreased whereas that of Ti₃O₅ slightly increased compared to that in the absence of sheath O₂ as shown quantitatively in Fig. 5. Highly reducing conditions result in SMSIs of Pd and Pt with TiO₂ that lead to formation of Ti₄O₂. For further reduction to Ti₃O₅, a radical reorganization of the structure may be required. The use of O₂ sheath during FSP increases the oxidation rate of the precursor solution and subsequently the high temperature residence time of the particles (Fig. 9). Therefore, Ti₃O₅ conversion from Ti₄O₇ (or directly from TiO₂), which requires a large amount of energy, seems to be facilitated by sheath O₂ during FSP synthesis of these core-shell nanostructures.

The 20Ag/TiO₂ NPs were black whereas the 10Ag/TiO₂ NPs were gray or light-brown (Fig. 1A). This color difference is due to enhanced light absorbance at visible wavelengths corresponding to the formation of titanium suboxides (Fig. 6). Interestingly, "black" TiO₂ prepared at high Ag loading (20Ag/TiO₂) and precursor concentration (X/Y = 8/5, green spectrum) exhibits greater absorption intensity in the visible range but lower in the UV than black TiO₂ prepared at more oxidative conditions, either at lower fuel concentration (X/Y = 3/5, orange spectrum) or with sheath O₂ (X/Y = 8/5, purple spectrum). Therefore, formation of this titanium suboxide is accelerated under reducing flame conditions. Worth noting is that external mixtures of commercial TiO₂ (P25) and flame-made nanosilver equivalent to that in 20Ag/TiO₂ show no visible light absorption (black broken line spectrum in Fig. 6).

Figure 2B shows the XRD patterns of 20Ag/TiO₂ NPs prepared at X/Y = 8/5 (green spectrum) and annealed at 350°C and 550°C in air for 2 h. These patterns indicate that the titanium suboxide phases are stable at 350°C but are transformed to rutile at 550°C with remnant Ti₃O₅ and Ti₄O₇. The UV absorption of 20Ag/TiO₂ NPs prepared at X/Y = 8/5 increased by annealing temperature, indicating oxidation of the suboxides (Fig. 7). Moreover, during this annealing, Ag⁰ particles were exposed by the decomposition of the suboxide phases, resulting in Ag⁰ sintering and crystal growth. The diffraction peak for Ag⁰ is no longer distorted but narrower and stronger upon annealing at 550°C : The Ag⁰ crystal size from 5.0 to 50.8 nm, exhibiting the plasmonic absorption of Ag around 550 nm and a stronger visible spectrum (Fig. 7).

Raman spectra of all FSP-made Ag/TiO₂ show new peaks at 246 and 361 cm⁻¹ and a shorter increase of the peak at 199 cm⁻¹ compared to that of commercial, flame-made P25. (Fig. 8). Analogous features have been observed in the Raman spectra of "black" TiO₂. However, some peaks (294, 690, 765, 849 and 938 cm⁻¹) detected for a non-crystalline Ti-suboxide shell are not detected here. Here, a new form of "black" Ti02 was prepared by the FSP process.

The preparation of the present "black" TiO₂ is based on a different physical mechanism than in wet-made "black" TiO₂: SMSIs between Ag⁰ and TiO₂ result in a crystalline suboxide layer (i.e. Ti₄O₇ and Ti₃O₅) that forms a shell around the silver NPs, which are strongly attached to a TiO₂ support nanoparticle. Distortion of the reduced phases could be responsible for the distribution of the density of states creating the so-called energy tails that extend into the band-gap energies of the semiconductor. This phenomenon is responsible for the absorbance of light at visible wavelengths, rendering the black color of the as prepared Ag/TiO₂ NPs. Here the reduced distorted phase of TiOₓ is attirbuted to a thin layer containing crystalline Ti₄O₇ and Ti₃O₅ as detected by XRD.

Figure 3 presents the low-temperature EPR spectra (77 K) of 20Ag/TiO₂ NPs prepared at X/Y = 8/5. No signal for carbon radicals was observed indicating that there is minimal, if any, incomplete combustion products on the NPs. In the dark, the NPs contain two types of paramagnetic centers: (I) a sharp axial signal with g =1.998 assigned to lattice electrons in the anatase phase (27) and (II) a broad signal extending from 3400 to 4000 G corresponding to the surface of Ti³⁺ electron trapping sites. Titanium suboxides are known to be rich in Ti³⁺ electron trapping sites which are easily detected by EPR spectroscopy (29). In pure Ti₄O₇ or Ti₃O₅ crystals, the Ti³⁺ centers belong to lattice oxygen vacancies of the type Te³⁺-Vₒ-Ti⁴⁺. Here, the Ti³⁺ EPR signals are broad indicating strain/distortion of the local environment around the Ti³⁺ centers.

Irradiation under visible-light wavelengths (Fig. 3: λ > 400 nm) rapidly photoinduces (< 30 s) three signals: A strong narrow axial signal appears at g = 1.980 is attributed to lattice electron (Ti³⁺) trapping sites located the interior of the crystal phase. The broader trough-like signal at g = 1.913 is a characteristic of superficial electron-trapping Ti³⁺ sites. This signal is significantly narrower than that typically produced by any surface-Ti³⁺ sites in P25. Its narrower linewidth indicates restricted mobility of the trapped Ti³⁺ electrons; therefore, it is assigned to Ti³⁺ states localized at the interface of TiO₂. In parallel with the Ti³⁺ signals at g < 2, photoinduced h⁺ centers are detected under illumination at g = 2.0016-2.0024.

Most importantly, the photogenerated e⁻ and h⁺ signals can be induced at high yield (> 80%) under visible-light irradiation at λ > 400 nm (Fig. 3). This high visible-light photoactivity is consistent with the enhanced UV-Vis absorbance (Fig. 6), which can be attributed to the generation of sub-band-gap energy tails from the distorted suboxide shell. Figure 4A shows the visible-light photocatalytic activity of commercial TiO₂ P25 (black circles) and present composite 20Ag/TiO₂ particles made at X/Y = 3/5 (orange triangles) and 8/5 (green squares) for reduction of Cr⁶⁺, a priority toxic pollutant. The half lives of Cr⁺⁶ were 30 and 55 min by 20Ag/TiO₂ NPs made at X/Y = 3/5 and 8/5, respectively. Furthermore, both photocatalysts are highly active also for Methylene blue degradation under visible light irradiation with even shorter half lives of 15 and 25 min the same NPs respectively (Fig. 4B). The faster kinetics of the NPs made at X/Y = 3/5 are consistent with their higher specific surface area (SSA) of 208 m²/g (Table 1), which is almost twice that (113 m²/g) of the NPs made at X/Y = 8/5. In comparison, the P25 (reference TiO₂) exhibited the well-known minor catalytic efficiency under visible light. Even though nanosilver on TiO₂ might slightly enhance the visible light photodegradation of phenol and Alizarin Red S, the present core-shell Ag/TiO₂-TiOₓ nanostructures exhibit a much stronger photoactivity due to the suboxide presence.

### LIST OF REFERENCE SIGNS

| | | | |
|---|---|---|---|
| 1 | nano-particle | 8 | 10Ag/ TiO₂(8/5) |
| 2 | core-particle of titanium dioxide | 9 | 20Ag/ TiO₂(3/5) |
| | | 10 | 20 Ag/ TiO₂ (8/5) |
| 3 | metal-nano-deposits on the surface of 2 | 11 | 20 Ag/ TiO₂ (8/5) with O₂ sheath |
| 4 | crystalline titanium-suboxide layer 4 | 12 | TiO₂(80%) + Ag (19%) + SiO₂(1%) |
| 5 | free surface of 2 | 13 | as prepared |
| 6 | P25 | 14 | annealed at 350°C |
| 7 | 10 Ag/ TiO₂ (3/5) | 15 | annealed at 550°C |

## Claims

1. Particle (1) with photoactivity under irradiation in the visible range of the electromagnetic spectrum comprising a nanoparticle architecture of a support or core-particle (2) of titanium dioxide with an average primary particle (as determined by nitrogen adsorption or microscopy) or crystallite (as determined by X-ray diffraction) diameter in the range of 3-300 nm;
on the surface of said core-particle (2) and attached thereto nanoparticles with an average diameter in the range of 2-90 nm (as determined by X-ray diffraction or microscopy) of at least one metal forming at least one nano-deposit (3) only partially covering said surface;
on the surface of said nano-deposit (3) a layer of titanium-suboxides (4) containing at least one crystalline titanium-suboxide component.

2. Particle (1) according to claim 1, wherein on the surface of said core-particle (2) at least one metal nano-deposit (3) is located, and wherein preferably the coverage of the total surface of said core-particle (2) by said metal nano deposits (3) is in the range of 0.2-50%.

3. Particle (1) according to claim 2, wherein preferably the coverage of the total surface of said core-particle (2) by said metal nano deposits (3) is in the range of 1-27%.

4. Particle (2) according to claim 2 or 3, wherein the layer of titanium-suboxides (4) containing at least one crystalline titanium suboxide component is at least partly contacting the free surface (5) of the core-particle (2) of titanium dioxide.

5. Particle (2) according to any of the preceding claims, wherein the titanium-suboxide (4) is selected from the group consisting of crystalline Ti₃O₅, crystalline Ti₄O₇, crystalline Ti₅O₉, or a mixture and/or aggregate thereof, wherein preferably it is selected from the group consisting of: crystalline Ti₃O₅, crystalline T₄O₇.

6. Particle (2) according to claim 5, wherein the crystalline mass ratio of Ti₃O₅,to Ti₄O₇ is chosen to be in the range of 1:6 to 6:1.

7. Particle (2) according to any of the preceding claims, wherein the weight ratio of the titanium dioxide of the core-particle (2) to the metal of the nano-deposits is in the range of 29:1 - 3:1.

8. Particle (2) according to any of the preceding claims, wherein the weight ratio of the titanium dioxide of the core-particle (2) to the metal of the nano-deposits is in the range of 12:1 -4:1.

9. Particle (2) according to any of the preceding claims, wherein the metal is selected from the group consisting of: silver, gold, nickel, cobalt, palladium, rhodium, iridium, platinum, copper or an alloy of a combination thereof.

10. Particle (2) according to any of the preceding claims, wherein the metal is selected to be silver or an alloy thereof.

11. Method for making a particle according to any of the preceding claims, wherein in a flame spray pyrolysis process titanium and metal precursors, preferably silver precursors, in flammable solvents are sprayed and dispersed by oxygen and combusted in a flame.

12. Method according to claim 11, wherein the weight ratio of the titanium and the metal precursors as present in the flammable solvent is adapted to be in the range of 29:1 - 3:1, preferably around 12:1-4:1.

13. Method according to any of the preceding claims, where additional oxygen as sheath is provided surrounding the flame spray pyrolysis process and facilitating partial oxidation of the product particle (2), (3) and (4).

14. Use of a particle according to any of the preceding claims 110, preferably made according to a method according to one of the claims 11-13, as a visible light photoactive material to be used as photo catalyst, or sensor or in solar energy utilisation or on photovoltaics.

15. Use according to claim 14, wherein it is used for oxidation reactions and/or photodegradation reactions, in particular of pollutants.
